# EUROPÄISCHE PATENTSCHRIFT

(11) **EP 0 656 136 B1**
(45) Veröffentlichungstag und Bekanntmachung des Hinweises auf die Patenterteilung: **28.02.1996**
(21) Anmeldenummer: 93917531.1
(22) Anmeldetag: 06.08.1993
(51) Int. Cl.: G06F 17/50

(54) **VERFAHREN ZUR ERZEUGUNG EINER AUS SCHALTKREISEN BESTEHENDEN SCHALTUNG MIT HILFE EINES RECHNERS**
PROCESS FOR PRODUCING A CIRCUIT CONSISTING OF INDIVIDUAL CIRCUITS WITH THE AID OF A COMPUTER
PROCEDE DE PRODUCTION ASSISTEE PAR ORDINATEUR DE CIRCUITS COMPOSES

(30) Priorität: 21.08.1992 DE 4227809
(43) Veröffentlichungstag der Anmeldung: 07.06.1995
(73) Patentinhaber: SIEMENS AKTIENGESELLSCHAFT, D-80333 München (DE)
(72) Erfinder: STOLL, Andreas, Dr., D-81549 München (DE)
(86) Internationale Anmeldenummer: DE9300701
(87) Internationale Veröffentlichungsnummer: WO9404986

(56) Entgegenhaltungen:
- 29TH ACM/IEEE DESIGN AUTOMATION CONFERENCE 8. Juni 1992 , ANAHEIM CA US Seiten 188 - 193 STOLL ET AL 'high-level synthesis from vhdl with exact timing constraints'
- EUROPEAN DESIGN AUTOMATION CONFERENCE EURO-VHDL '92 7. September 1992 , HAMBURG DE Seiten 610 - 615 STOLL ET ALL 'flexible timing specification in a vhdl synthesis subset'
- Biesenack, J. et al: "Synthese - Entwurfsmethode der Zukunft" Elektronik, 1989, 23, Spezialteil ASIC, Seiten 19-39

## Beschreibung

Die Spezifikation komplexer integrierter Schaltungen kann auf verschiedenen Abstraktionsebenen erfolgen. Dazu kann eine Hardware-Beschreibungssprache, z.B. VHDL, verwendet werden. Eine Validierung der Spezifikation durch kommerziell verfügbare Simulatoren ist möglich, so daß überprüft werden kann, ob die Spezifikation die Design Aufgabe auch erfüllt.

Wenn die Spezifikation erstellt worden ist, wird mit Hilfe eines Synthese-Programms die Spezifikation auf eine tiefere Abstraktionsebene überführt und z.B. mit einem High-Level-Synthese Programm Schaltungen auf Register-Transfer-Ebene erzeugt. Dieses Verfahren ist z.B. beschrieben in M.McFarland, A.Parker and R.Camposano, "The highlevel synthesis of digital systems", in Proceeedings of the IEEE, Vol. 78, Seite 301 bis 318, Febr. 1990. Einen Überblick zu Synthesemethoden wird in Biesenack et al.: "Synthese-Entwurfsmethode der Zukunft" Elektronik, 1989, H. 23, Seiten 19-39 des Sonderteils ASIC, gegeben. Gängige Design-Automatisierungssysteme unterstützen somit den weiteren Entwurfsweg. Sofern die synthetisierten Schaltungen nicht rein kombinatorisch sind, arbeiten sie voll synchron mit einem globalen Taktsignal und sind aus einem Datenpfad mit einem Controller aufgebaut. Die Schaltung ist stets ein Moore-Automat, der jeweils durch die steigende Taktflanke in seinem nächsten Zustand überführt wird.

Der Nutzen der High-Level-Synthese hängt von der positiven Beantwortung der zwei folgenden Fragen ab:
- Kann auf einfache Weise untermauert werden, daß jede Schaltung, die der Spezifikation entspricht, die Design-Aufgabe erfüllt?
- Kann die Synthese für die gegebene Spezifikation stets eine möglichst gute Schaltungsrealisierung finden?

Diese beiden Ziele sind allerdings bezüglich der Spezifikation des zeitlichen Schaltungsverhaltens gegenläufig: Das Optimierungspotential der Synthese vergrößert sich drastisch, wenn das zeitliche Interface-Verhalten des erzeugten Moore-Automaten verändert werden darf; eine algorithmische Spezifikation, die dies erlaubt, kann jedoch im allgemeinen nicht ohne weiteres durch Simulation validiert werden, weil übliche Simulatoren keine zeitlichen Freiheitsgrade kennen. Daher läßt sich erst durch Simulation des Synthese-Ergebnisses feststellen, ob die Schaltung richtig mit ihrer Umgebung kommuniziert, obwohl dies schon vor Synthese durch die Spezifikation sicherzustellen ist.

Die der Erfindung zugrundeliegende Aufgabe besteht darin, ein Verfahren zur Erzeugung einer aus Schaltkreisen bestehenden Schaltung mit Hilfe eines Rechners anzugeben, bei dem die Spezifikation des zeitlichen Schaltungsverhaltens derart ist, daß die obengenannten beiden Fragen positiv beantwortet werden können. Diese Aufgabe wird gemäß den Merkmalen des Patentanspruchs 1 gelöst.

Das High-Level-Synthese Programm setzt üblicherweise eine algorithmische Schaltungsspezifikation zunächst in eine interne Flußgraphdarstellung um. Dementsprechend soll im folgenden die Erfindung anhand einer solchen Darstellung (vgl. R.Camposano und R.Tabet "Design representation for the synthesis of behavioral VHDL models" in CHDL, Proc. of the Ninth IFIP Symposium 1989) beschrieben werden. Der Flußgraph ist ein gerichteter Graph, dessen Knoten die Operationen in der algorithmischen Spezifikation sind.

Die Kanten sind durch die sequentielle Abarbeitungsreihenfolge der Operationen definiert. Die Zeit-Spezifikation von Lese-und Schreibsignalen (Eingangssignale, Ausgangssignale der auszuwählenden Schaltkreise) wird im Flußgraphen durch sog. Zeitknoten ausgedrückt, die mit folgenden das Zeitverhalten der Schaltung festlegenden Attributen versehen sind:
- Das Zeitverhalten ausgedrückt in Taktzyklen kann eine positive natürliche Zahl tv sein, die bei der Spezifikation vorgegeben wird;
- das Zeitverhalten kann durch eine Anzahl von Taktzyklen t₍ᵢ₎(positive natürliche Zahl) festgelegt werden, die erst später von dem Syntheseprogramm zu bestimmen ist, also erst nach der High-Level-Synthese durch eine Zahl ersetzt wird;
- oder es wird eine unbestimmte Zeit an Taktzyklen, im folgenden mit "∞" bezeichnet, eingesetzt, die erst nach Auswahl des Schaltkreises nach der Synthese festgelegt werden kann; dies ist z.B. dann sinnvoll, wenn das zeitliche Verhalten eines zu wählenden Schaltkreises pfadabhängig sein kann.

Die Zeitknoten haben folgende Semantik:
Wird beim Wandern durch den Flußgraphen ein Zeitknoten überschritten, so erhöht sich die aktuelle Zeit - angegeben in Taktzyklen - um dessen Zeitattribut. Durch diese aktuelle Zeit werden nur die Ausführungszeitpunkte der Interfacezugriffe festgelegt, d.h. derjenigen Knoten, die einer Leseoder Schreiboperation entsprechen, während die Ausführungszeitpunkte aller übrigen Operationen nur durch deren Datenabhängigkeiten beschränkt sind.

Tritt ein Zeitknoten mit der Konstante tᵢ auf, dann heißt dies, daß diese Konstante während der Spezifikation noch nicht vorliegt, sondern die Synthese über die symbolische Konstante tᵢ noch optimal verfügen darf. Das Zeitattribut ∞ bedeutet, daß die Synthese eine beliebige Anzahl von Taktzyklen einschieben darf, bis die neuen Werte der Ausgangssignale zugewiesen werden und ein weiterer Taktzyklus vergeht. Dieser Zeitpunkt "ein Taktzyklus nach Signalwech- sel" ist dann ein relativer Bezugspunkt für die nachfolgenden Zeitattribute.

Bei Verwendung dieser Zeitspezifikation erhält die High-Level-Synthese genügend Freiheitsgrade, so daß bekannte Verfahren (z.B. R.Camposano, Path-based scheduling for synthesis", IEEE Transactions on Computer-Aided Design, vol. 10, pp. 85-93, Jan. 1991) angewendet werden können.

Trotz dieser Vorgehensweise ist die Simulation zur Validierung der zu synthetisierenden Spezifikationen möglich, obwohl für das Syntheseergebnis und die Spezifikation unterschiedliches zeitliches Verhalten simuliert wird. Deshalb läßt sich bei korrekter Synthese jeder Spezifikationsfehler, der durch Simulation des Ergebnisses nach Synthese gefunden wird, bereits durch Simulation der algorithmischen Spezifikation vor Synthese aufdecken.

Um diese Simulationen zu ermöglichen, ist erforderlich, daß das Auftreten eines Zeitknotens "∞" stets mit einem Ready-Signal verbunden wird, so daß die Umgebung des Schaltkreises auf dieses Ready-Signal wartet. Im Falle der Konstanten tᵢ kann sich die Umgebung des Schaltkreises auf jeden Wert einstellen, den die Synthese wählen kann. Die High-Level-Synthese kann die gewählten Werte für die konstanten tᵢ in der ursprünglichen algorithmischen Spezifikation später einsetzen, so daß zur Absicherung der korrekten Arbeitsweise noch ein weiteres Mal die Spezifikation simuliert werden kann.

Der Vorteil des Verfahrens besteht darin, daß ausgehend von der Schaltungspezifikation auf algorithmischer Ebene durch die Wahl der entsprechenden Zeitattribute die Freiheitsgrade des Hig-Level-Synthese-Programm nicht unnötig eingeschränkt wird. Der Synthese ist es also möglich, aus den vorhandenen oder zu realisierenden Schaltkreisen solche zu wählen, die die Spezifikation am besten erfüllen. Trotzdem ist eine Validierung sowohl auf Spezifikationsebene als auch nach der High Level-Synthese möglich. Das Zeitattribut wird dabei bei der Simulation durch einen festen bei der High-Level-Synthese möglichen Wert eingestellt, daß Zeitattribut ∞ wird mit einem Ready-Signal verbunden, so daß das Simulatorprogramm weiß, daß die Taktzyklenzeit noch nicht festliegt und eventuell einen geschätzten Wert dafür einsetzt.

## Patentansprüche

1. Verfahren zum Entwurf einer aus Schaltkreisen bestehenden Schaltung mit Hilfe eines Rechners,
- bei dem die Schaltung auf algorithmischer Ebene spezifiziert wird und diese Spezifikation durch ein Synthese-Programm in Schaltkreise auf Register-Transfer-Ebene übersetzt wird
- bei dem in der Spezifikation auf algorithmischer Ebene entsprechend dem zeitlichen Verhalten eines auszusuchenden Schaltkreises zwischen dem Lesen der Eingangssignale und dem Schreiben der Ausgangsignale jeweils in Taktzyklen bei der Spezifikation entweder
- eine feste Zeit t_{V} bei der Spezifikation vorgegeben wird,
- eine vom Synthese-Programm festzulegende konstante Zeit t₍ᵢ₎ eingesetzt wird,
oder eine zunächst unbestimmte Zeit ∞ eingesetzt wird, die erst nach Auswahl des Schaltkreises festzulegen ist.

2. Verfahren nach Anspruch 1,
bei dem bei der Validierung der Spezifikation auf algorithmischer Ebene durch ein Simulatorprogramm die Zeit "∞" durch einen geschätzten Wert ersetzt wird.

3. Verfahren nach Anspruch 1 oder 2,
bei dem das Zeitattribut "∞" dann eingesetzt wird, wenn das zeitliche Verhalten dieses Schaltkreises pfadabhängig ist.

## Claims

1. Method for designing a circuit arrangement comprising circuits with the aid of a computer,
- in which the circuit arrangement is specified on an algorithmic plane and this specification is translated by a synthesis program into circuits on the register-transfer plane,
- in which in the specification on an algorithmic plane in accordance with the time response of a circuit to be selected, it is the case that in the specification, in clock cycles in each instance, between the reading of the input signals and the writing of the output signals either
- a fixed time t_{V} is prescribed in the specification, and
- a constant time t₍ᵢ₎ which is to be established by the synthesis program is used,
or an initially indeterminate time ∞ is used which is not to be established until after selection of the circuit.

2. Method according to Claim 1, in which in the validation of the specification on an algorithmic plane by a simulator program the time "∞" is replaced by an estimated value.

3. Method according to Claim 1 or 2, in which the time attribute "∞" is used whenever the time response of this circuit is a function of path.

## Revendications

1. Procédé de conception assistée par ordinateur de circuits composés
- dans lequel le circuit est spécifié au niveau algorithmique et dans lequel un programme de synthèse transpose cette spécification dans des circuits au niveau du transfert registre à registre;
- dans lequel, dans la spécification au niveau algorithmique, selon le comportement temporel d'un circuit à rechercher, entre la lecture des signaux d'entrée et l'écriture des signaux de sortie, chaque fois exprimé en cycles d'horloge lors de la spécification, soit
- un temps fixe tᵥ est prédéfini lors de la spécification,
- un temps constant t₍ᵢ₎ à déterminer par le programme de synthèse est utilisé,
soit un temps initialement indéterminé ∞ est utilisé et ne doit être déterminé qu'après avoir choisi le circuit.

2. Procédé selon la revendication 1, dans lequel, lors de la validation de la spécification au niveau algorithmique par un programme de simulateur, le temps "∞" est remplacé par une valeur estimée.

3. Procédé selon la revendication 1 ou 2, dans lequel l'attribut temporel"∞" est utilisé lorsque le comportement temporel de ce circuit dépend du chemin.
